# EUROPÄISCHE PATENTSCHRIFT

(11) **EP 1 683 245 B1**
(45) Veröffentlichungstag und Bekanntmachung des Hinweises auf die Patenterteilung: **15.06.2011**
(21) Anmeldenummer: 04802694.2
(22) Anmeldetag: 09.11.2004
(51) Int. Cl.: H01S 5/183, H01S 5/04

(54) **MONOLITHISCHER OPTISCH GEPUMPTER VCSEL MIT SEITLICH ANGEBRACHTEM KANTENEMITTER**
VCSEL PUMPED IN A MONOLITHICALLY OPTICAL MANNER AND COMPRISING A LATERALLY APPLIED EDGE EMITTER
VCSEL MONOLITHIQUE A POMPAGE OPTIQUE COMPRENANT UN EMETTEUR A EMISSION PAR LA TRANCHE PLACE LATERALEMENT

(30) Priorität: 13.11.2003 DE 10353216
(43) Veröffentlichungstag der Anmeldung: 26.07.2006
(73) Patentinhaber: OSRAM Opto Semiconductors GmbH, 93055 Regensburg (DE)
(72) Erfinder: ALBRECHT, Tony, 93077 Bad Abbach (DE); BRICK, Peter, 93049 Regensburg (DE); LUTGEN, Stephan, 93049 Regensburg (DE)
(74) Vertreter: Epping - Hermann - Fischer
(86) Internationale Anmeldenummer: PCT/DE2004/002477
(87) Internationale Veröffentlichungsnummer: WO 2005/048424

(56) Entgegenhaltungen:
- WO-A-03/094311
- DE-A1- 10 129 616
- DE-A1- 10 214 120
- JP-A- 2003 283 051
- US-A1- 2002 075 929
- US-A1- 2003 007 538

## Beschreibung

Die Erfindung betrifft eine Halbleiterlaservorrichtung mit einem optisch gepumpten, oberflächenemittierenden Vertikalemitterbereich, der eine aktive strahlungserzeugende Vertikalemitterschicht aufweist und mindestens einer monolithisch integrierten Pumpstrahlungsquelle zum optischen Pumpen des Vertikalemitterbereichs, die einen lateralen Pumpwellenleiter mit einer aktiven strahlungserzeugende Pumpschicht aufweist.

Die Druckschrift US 2003/0 007 538 A zeigt eine Halbleiterlaservorrichtung mit einem optisch gepumpten, oberflächenemittierenden Vertikalemitterbereich und einer integrierten Pumpstrahlungsquelle.

Es wird eine optisch gepumpte, oberflächenemittierende Halbleiterlaservorrichtung mit einem Verstärkerbereich als Vertikalemitterbereich und mindestens einem kantenemittierenden Halbleiterlaser als Pumpstrahlungsquelle beschrieben. Der Vertikalemitterbereich und die Pumpstrahlungsquelle sind auf einem gemeinsamen Substrat epitaktisch aufgewachsen. Auf diese Weise lässt sich eine platzsparende monolithisch integrierte Anordnung von Vertikalemitterbereich und Pumpstrahlungsquellen realisieren.

Eine hohe Pumpeffizienz und damit hohe Ausgangsleistung des Vertikalemitters wird erreicht, wenn die Wellenlänge der Pumpstrahlungsquelle kleiner ist als die Wellenlänge der vom Vertikalemitter abgegebenen Strahlung. Dieses lässt sich beispielsweise durch verschiedene Materialzusammensetzungen der strahlungserzeugenden Pump- bzw. Vertikalemitterschicht oder durch verschiedene Dimensionierung dieser Schichten erreichen.

Ein typischer Herstellungsweg für eine solche Halbleiterlaservorrichtung ist, auf einem Substrat zunächst großflächig die Schichten für den Vertikalemitterbereich epitaktisch aufzuwachsen. Anschließend werden in den lateralen Bereichen, die für die Pumpstrahlungsquellen vorgesehen sind, diese Schichten selektiv wieder abgeätzt. In einem zweiten Epitaxieschritt werden dann schließlich in diesen Bereichen die Schichten der Pumpstrahlungsquellen epitaktisch aufgewachsen.

Ein solcher Zweischritt-Epixatieprozess ist aus mehreren Gründen ungünstig. Im Übergangsbereich zwischen Pumpstrahlungsquellen und Vertikalemitterbereich lassen sich Korngrenzen und eine erhöhte Defektdichte nur schwer vermeiden, was zu optischen Absorptionsverlusten an dieser Stelle führt. Weiterhin kann die Kante des Vertikalemitterbereichs den Wachstumsmodus der Schichten der Pumpstrahlungsquellen im Übergangsbereich beeinflussen, was in einer nachteiligen Abweichung der Schichtdicken in diesem Übergangsbereich resultieren kann. Darüber hinaus ist der Zweitschritt-Epitaxieprozess mit hohem Fertigungsaufwand verbunden.

Aus Gerhold et al., IEEE Journal of Quantum Electronics, Volume 34 Nr. 3 1998, Seite 506-511, ist eine optisch gepumpte Halbleiterlaservorrichtung, hergestellt in einer Einschritt-Epitaxie, bekannt. Vertikalemitterbereich und Pumpstrahlungsquellen weisen eine gemeinsame aktive Schicht mit einer Quantentopfstruktur auf. In dem als Pumpstrahlungsquelle eingesetzten Bereich ist die Quantentopfstruktur mit Fremdatomen durchmischt, was in diesem Bereich zur Erzeugung von Strahlung mit einer kürzeren Wellenlänge als im Vertikalemitterbereich führt (IILD - Impurity Induced Layer Disordering). Die Methode der Durchmischung mit Fremdatomen erlaubt allerdings nur kleine Variationen der Wellenlänge und birgt zudem die Gefahr, dass die Effektivität der Strahlungserzeugung und damit die Pumpeffizienz absinkt.

Ein generelles Problem bei optisch gepumpten Halbleiterlaservorrichtungen, die in einer Einschritt-Epitaxie hergestellt sind, stellt der zunächst einmal gleiche Schichtaufbau von Vertikalemitterbereich und Pumpstrahlungsquellen dar. Idealerweise sollte im Betrieb nur im Bereich der Pumpstrahlungsquellen ein sich lateral ausbreitendes Strahlungsfeld erzeugt werden und im Vertikalemitterbereich sollte nur ein sich in vertikaler Richtung ausbreitendes Strahlungsfeld erzeugt werden. Vertikal propagierende Moden im Bereich der Pumpstrahlungsquellen vermindern die erzeugte Pumpstrahlungsleistung. Analog vermindern sich im Vertikalemitterbereich erzeugte lateral ausbreitende Strahlungsmoden die Besetzungsinversion und damit die Pumpeffizient. Eine effizient arbeitende Halbleiterlaservorrichtung der genannten Art setzt somit die Aufhebung der Gleichberechtigung von Pumpschicht und Vertikalemitterschicht voraus.

Es ist daher eine Aufgabe der vorliegenden Erfindung, eine optisch gepumpte Halbleiterlaservorrichtung zu schaffen, die eine hohe Pumpeffizienz aufweist und die in einem Einschritt-Epitaxieverfahren herstellbar ist.

Diese Aufgabe wird durch eine Halbleiterlaservorrichtung mit den Merkmalen des Patentanspruchs 1 gelöst. Vorteilhafte Weiterbildungen der Erfindung sind Gegenstand der abhängigen Ansprüche.

Erfindungsgemäß ist die Pumpschicht der Vertikalemitterschicht in vertikaler Richtung nachgeordnet und es ist eine elektrisch leitende Schicht zwischen der Vertikalemitterschicht und der Pumpschicht vorgesehen. Weiterhin ist auf der Seite der Halbleiterlaservorrichtung, die sich näher an der Pumpschicht als an der elektrisch leitenden Schicht befindet, ein Kontakt aufgebracht. Zwischen diesem Kontakt und der elektrisch leitenden Schicht ist ein elektrisches Feld zur Erzeugung von Pumpstrahlung durch Ladungsträgerinjektion anlegbar. Der Pumpwellenleiter weist einen lateralen Bereich mit einem von dem übrigen Teil des Pumpwellenleiters abweichenden Brechungsindex auf, durch den die Pumpstrahlung in Richtung der Vertikalemitterschicht gebrochen wird. Eine vertikale Wellenleiterstruktur ist derart vorgesehen, dass die Pumpstrahlung die Vertikalemitterschicht erreicht.

Die Vertikalemitterschicht und die Pumpschicht sind vertikal voneinander getrennte, nacheinander aufgewachsene Schichten. Dieser Aufbau gewährleistet große Freiheit bezüglich der Wahl der Materialien und Dimensionierung für diese Schichten. Dadurch kann die Wellenlänge der Pumpstrahlung sowie der vertikal emittierten Strahlung in weiten Grenzen eingestellt werden, wodurch eine hohe Pumpeffizienz erreichbar ist. Die erfindungsgemäße Anordnung der elektrisch leitenden Schicht und des Kontakts auf der Seite der Halbleiterlaservorrichtung führt dazu, dass durch ein zwischen dieser elektrisch leitenden Schicht und dem Kontakt angelegtes elektrisches Feld Ladungsträger selektiv in die Pumpschicht und nicht in die Vertikalemitterschicht injiziert werden. In der Vertikalemitterschicht wird somit die Anregung von parasitärer, lateral propagierender Strahlung verhindert.

Vorzugsweise wird die Halbleiterlaservorrichtung teilweise abgetragen, sodass die elektrisch leitende Schicht teilweise freigelegt ist. In einer Ausführungsform der Erfindung kann die Halbleiterlaservorrichtung in Form von parallelen Gräben abgetragen sein. Besonders bevorzugt ist, dass auf die freigelegten Bereiche der elektrisch leitenden Schicht ein weiterer Kontakt zur Kontaktierung dieser elektrisch leitenden Schicht aufgebracht ist.

In einer weiteren Ausgestaltung der Erfindung ist zwischen der elektrisch leitenden Schicht und dem weiteren Kontakt eine Schicht vorgesehen, die elektrisch leitend ist und die für Strahlung einer Wellenlänge, wie sie von dem Vertikalemitterbereich erzeugt wird, transparent ist.

Zur Herstellung der erfindungsgemäßen Halbleiterlaservorrichtung ist ein einziger Epitaxie-Prozess ausreichend. Selbst wenn, wie in den zuvor beschriebenen Ausführungsformen, Schichten teilweise wieder abgetragen werden und weitere Schichten oder Kontakte aufgebracht werden, kann dieses ohne einen technologisch aufwändigen zweiten Epitaxieschritt durchgeführt werden.

In einer weiteren Ausführungsform ist, um das Abtragen der Halbleiterlaservorrichtung kontrolliert beenden zu können, benachbart zur elektrisch leitenden Schicht eine Ätzstoppschicht vorgesehen, die resistent gegenüber einem Ätzprozess ist, der geeignet ist, die elektrisch leitende Schicht freizulegen.

Es ist günstig, die elektrisch leitende Schicht vertikal so anzuordnen, dass sie sich in einem Knoten des Stehwellenfeldes in dem Resonator des Vertikalemitters befindet. Dadurch werden optische Verluste im Vertikalemitterbereich durch die elektrisch leitende Schicht minimiert.

In einer bevorzugten Ausgestaltung der Erfindung ist zwischen der Vertikalemitterschicht und der elektrisch leitenden Schicht die vertikale Wellenleiterstruktur vorgesehen. Bevorzugt ist, dass die vertikale Wellenleiterstruktur in dem Bereich, in dem sie, lateral gesehen, zwischen dem Kontakt und dem weiteren Kontakt liegt, andere optische Eigenschaften aufweist als in dem Bereich, in dem sie nicht zwischen dem Kontakt und dem weiteren Kontakt liegt.

Die Vertikalemitterschicht und die Pumpschicht sind in vertikaler Richtung nachgeordnet. Die Hauptstrahlungsrichtung der Pumpstrahlung ist lateral. Damit die Pumpstrahlung zum optischen Pumpen die Vertikalemitterschicht überhaupt erreicht, muss es einen Bereich geben, in dem die Pumpstrahlung auch in vertikaler Richtung propagieren kann. Diesem Zweck dient die vertikale Wellenleiterstruktur. Dabei ist es wünschenswert, dass eine vertikale Ausbreitung der Pumpstrahlung im Vertikalemitterbereich gut ausgeprägt ist, wohingegen sie im Bereich der Pumpstrahlungsquellen möglichst unterdrückt sein sollte. Dieses wird erfindungsgemäß dadurch erreicht, dass im Bereich der Pumpstrahlungsquellen, also zwischen dem Kontakt und dem weiteren Kontakt, die vertikale Wellenleiterstruktur andere optische Eigenschaften aufweist als in dem Vertikalemitterbereich, also in dem Bereich, in dem sie nicht zwischen dem Kontakt und dem weiteren Kontakt liegt.

In einer vorteilhaften Weiterbildung der Erfindung wird ein Unterschied in den optischen Eigenschaften dadurch erreicht, dass die vertikale Wellenleiterstruktur in dem Bereich, in dem sie, lateral gesehen, zwischen dem Kontakt und dem weiteren Kontakt liegt, oxidiert ist.

In einer vorteilhaften Ausführungsform der Erfindung ist der Pumpschicht und der Vertikalemitterschicht in vertikaler Richtung eine interne Resonator-Spiegelstruktur nachgeordnet, welche besonders bevorzugt ein Bragg-Reflektor ist. In einer Weiterbildung der Erfindung ist die interne Resonator-Spiegelstruktur zwischen der Vertikalemitterschicht und einem Substrat angeordnet und die von der Vertikalemitterschicht erzeugte Strahlung wird auf der dem Substrat gegenüberliegenden Seite ausgekoppelt.

In einer weiteren Ausgestaltung der Erfindung ist der Vertikalemitterschicht ein externer Spiegel zugeordnet, der zusammen mit der internen Resonator-Spiegelstruktur den Resonator für den Vertikalemitterbereich bildet. In einer bevorzugten Ausgestaltung der Erfindung sind im Resonator strahlformende Elemente oder frequenzselektive Elemente oder frequenzkonvertierende Elemente angeordnet.

Eine vorteilhafte Weiterbildung der Erfindung besteht darin, dass die Vertikalemitterschicht und/oder die Pumpschicht jeweils eine oder mehrere Quantentopfstrukturen aufweist, wobei die Bezeichnung Quantentopfstruktur im Rahmen der Anmeldung jegliche Struktur umfasst, bei der Ladungsträger durch Einschluss (confinement) eine Quantisierung ihrer Energiezustände erfahren. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen.

Im Folgenden ist die Erfindung anhand von verschiedenen Ausführungsbeispielen unter Zuhilfenahme von zwölf Figuren näher erläutert.

Es zeigen:
Figur 1 eine schematische Schnittansicht eines ersten Ausführungsbeispiels einer erfindungsgemäßen Halbleiterlaservorrichtung,
Figur 2 eine dreidimensionale schematische Schnittdarstellung des ersten Ausführungsbeispiels,
Figur 3 eine schematische Aufsicht auf ein zweites Ausführungsbeispiel einer erfindungsgemäßen Halbleiterlaservorrichtung,
Figur 4 eine schematische Schnittansicht des zweiten Ausführungsbeispiels entlang der in der Figur 3 dargestellten Schnittlinie AA,
Figur 5 eine schematische Schnittansicht des zweiten Ausführungsbeispiels entlang der in Figur 3 dargestellten Schnittlinie BB,
Figur 6 eine schematische Aufsicht eines dritten Ausführungsbeispiels einer erfindungsgemäßen Halbleiterlaservorrichtung,
Figur 7 eine schematische Schnittansicht des dritten Ausführungsbeispiels entlang der in Figur 6 eingezeichneten Schnittlinie AA,
Figur 8 eine schematische Schnittdarstellung des dritten Ausführungsbeispiels entlang der in Figur 6 eingezeichneten Schnittlinie BB,
Figur 9 eine graphische Darstellung der Überlappung von Pump- und Vertikalemitter-Moden im Vertikalemitterbereich,
Figur 10 eine graphische Darstellung der Ausbreitung der Pumpstrahlung in vertikaler Richtung im Vertikalemitterbereich,
Figur 11 eine schematische Aufsicht auf verschiedene Ausführungsbeispiele einer erfindungsgemäßen Halbleiterlaservorrichtung zur Illustration möglicher Anordnung von Pumpstrahlungsquelle und Vertikalemitterbereich und
Figur 12 eine schematische Aufsicht auf ein weiteres Ausführungsbeispiel der erfindungsgemäßen Halbleiterlaservorrichtung zur Darstellung einer weiteren möglichen Anordnung von Pumpstrahlungsquelle und Vertikalemitterbereich.

Gleiche oder gleich wirkende Elemente sind in den Figuren mit denselben Bezugszeichen versehen. Die Figuren sind schematische Zeichnungen. Insbesondere sind die Größenverhältnisse der Elemente nicht maßstabsgerecht dargestellt.

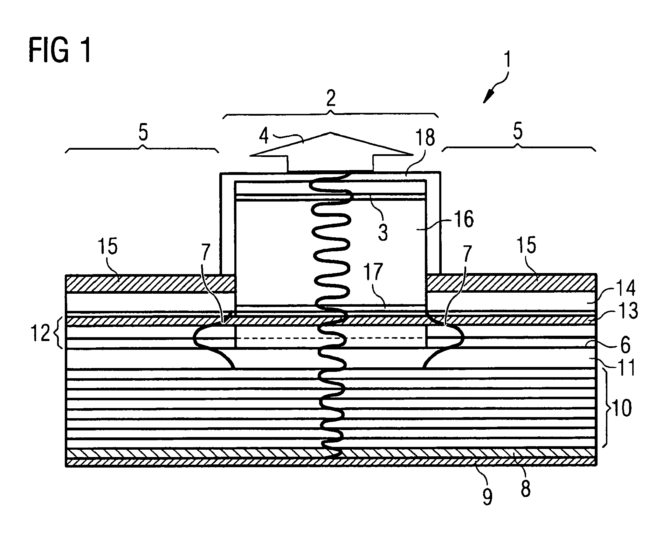

Figur 1 zeigt ein erstes Ausführungsbeispiel einer erfindungsgemäßen Halbleiterlaservorrichtung. In einem Halbleiterkörper 1 ist zentral ein Vertikalemitterbereich 2 angeordnet. Der Vertikalemitterbereich 2 weist als aktives Element eine Vertikalemitterschicht 3 zur Erzeugung eines Strahlungsfeldes 4 auf. Das Strahlungsfeld 4 ist innerhalb des Halbleiterkörpers 1 schematisch als Wellenzug dargestellt. Seitlich benachbart zum Vertikalemitterbereich 2 sind Pumpstrahlungsquellen 5 angeordnet. Sie weisen eine Pumpschicht 6 zur Erzeugung einer Pumpstrahlung 7 zum optischen Pumpen der Vertikalemitterschicht 3 auf. Die Pumpstrahlung 7 ist schematisch durch ihr gauß-ähnliches Intensitätsprofil senkrecht zur Pumpschicht 6 angedeutet.

Der Vertikalemitterbereich 2 und die Pumpstrahlungsquellen 5 sind gemeinsam epitaktisch auf einem Substrat 8 aufgewachsen, das auf einer Seite mit einem Kontakt 9 versehen ist. Auf die dem Kontakt 9 abgewandten Seite des Substrats 8 ist eine Bragg-Spiegelstruktur 10 aufgebracht und nachfolgend eine Mantelschicht 11. An die Mantelschicht 11 schließt sich auf der dem Substrat 8 abgewandten Seite ein Pumpwellenleiter 12 an, der als zentrales Element die Pumpschicht 6 beinhaltet. Der Pumpwellenleiter 12 wird auf der dem Substrat 8 abgewandten Seite von einer elektrisch leitenden Schicht 13 begrenzt, auf die im Bereich der Pumpstrahlungsquellen 5 eine leitende und transparente Schicht 14 aufgebracht ist. Die leitende und transparente Schicht 14 ist auf der dem Substrat 8 abgewandten Seite mit einem weiteren Kontakt 15 versehen.

Innerhalb des Vertikalemitterbereichs 2 weist die Halbleiterlaservorrichtung eine der elektrisch leitenden Schicht 13 auf der dem Substrat 8 abgewandten Seite vertikal nachgeordnete vertikale Wellenleiterstruktur 16 auf, die neben der Vertikalemitterschicht 3 eine Ätzstoppschicht 17 beinhaltet. Zudem ist ein Fenster 18 vorgesehen, das den Vertikalemitterbereich 2 auf der dem Substrat 8 abgewandten Seite begrenzt und durch das das Strahlungsfeld 4 den Halbleiterkörper 1 verlassen kann.

Geeignete Materialsysteme zur Realisierung der Erfindung finden sich in der Gruppe der III-IV Verbindungshalbleiter. Das gezeigte Ausführungsbeispiel kann beispielsweise auf der Basis des (AlₓIn₁₋ₓ)yGa_{1-y}As_{z}P_{1-z} mit 0≤x≤1, 0≤y≤1, 0≤z≤1 realisiert werden. Andere mögliche Materialsysteme basieren auf GaN oder InP, je nach gewünschter Wellenlänge.

Selbstverständlich ist die Erfindung aber nicht auf dieses Materialsystem beschränkt, sondern kann je nach gewünschter Wellenlänge oder sonstiger Anforderungen auch auf Basis eines anderen Materialsystems aufgebaut sein.

Die Pumpstrahlungsquellen 5 sind als kantenemittierende, elektrisch gepumpte Halbleiterlaser ausgeführt, deren Hauptstrahlungsrichtung auf den Vertikalemitterbereich 2 zeigt. Die von dem Vertikalemitterbereich 2 abgewandten, parallel zueinander liegenden Endflächen der Pumpstrahlungsquellen 5 sind spiegelnd ausgebildet und dienen als Resonatorspiegel für die Pumpstrahlung 7. Diese Endflächen können vorteilhafterweise durch Spalten oder aber auch durch Ätzen erzeugt sein und optional hochreflektierend verspiegelt sein. Im gezeigten Ausführungsbeispiel bilden beide Pumpstrahlungsquellen 5 einen einzigen, kohärent schwingenden Laser.

Die Pumpschicht 6 kann beispielsweise durch einen einzelnen Quantentopf (SQW, Single Quantum Well) oder als eine Schichtabfolge mehrerer Quantentöpfe (MQW, Muliple Quantum Wells) realisiert werden. Der oder die Quantentöpfe werden typischerweise in Barriereschichten eingebettet, wodurch der Pumpwellenleiter 12 gebildet wird.

Zum Betrieb der Halbleiterlaservorrichtung werden über den Kontakt 9 und den weiteren Kontakt 15 Ladungsträger in den Halbleiterkörper 1 injiziert, die in der Pumpschicht 6 strahlend rekombinieren, wodurch die Pumpstrahlung 7 aufgebaut wird. Um eine ausreichende Stromleitfähigkeit zu erreichen, müssen alle Strom führenden Schichten des Halbleiterkörpers 1 hinreichend dotiert sein. Allerdings führen direkt an den Pumpwellenleiter 12 angrenzende leitfähige Schichten zu signifikant hohen optischen Verlusten durch Strahlungsabsorption an freien Ladungsträgern.

Vorzugsweise sind aus diesem Grund die direkt an den Pumpwellenleiter 12 angrenzenden Schichten der Bragg-Spiegelstruktur 10 niedriger zu dotieren. Alternativ ist möglich, auf die dotierte Bragg-Spiegelstruktur 10 eine weniger hoch dotierte Mantelschicht 11 aufzubingen, wie im Ausführungsbeispiel in Figur 1 gezeigt ist.

Auf der gegenüberliegenden Seite des Pumpwellenleiters 12 ist aus dem gleichen Grund der weitere Kontakt 15 nicht direkt auf den Pumpwellenleiter 12 aufgebracht. Die hier zusätzlich eingefügte leitende und transparente Schicht 14 ist idealerweise leitend für elektrischen Strom, wodurch sie den Anforderungen für eine gute Stromeinprägung genügt und ist gleichzeitig transparent für die Pumpstrahlung 7, wodurch optische Verluste minimiert werden. Ein mögliches Material für eine solche Schicht stellt beispielsweise Indium-Zinnoxid (ITO - Indium Tin Oxide) oder eine zinkoxidhaltige Verbindung dar.

Die zwischen dem Pumpwellenleiter 12 und der leitenden und transparenten Schicht 14 angeordnete elektrisch leitende Schicht 13 dient der lateralen Stromverteilung und weitet den gepumpten Bereich der Pumpstrahlungsquellen 5 bis in den Vertikalemitters 2 aus. Um optische Verluste an der elektrisch leitenden Schicht 13 gering zu halten, ist diese vergleichsweise dünn ausgeführt.

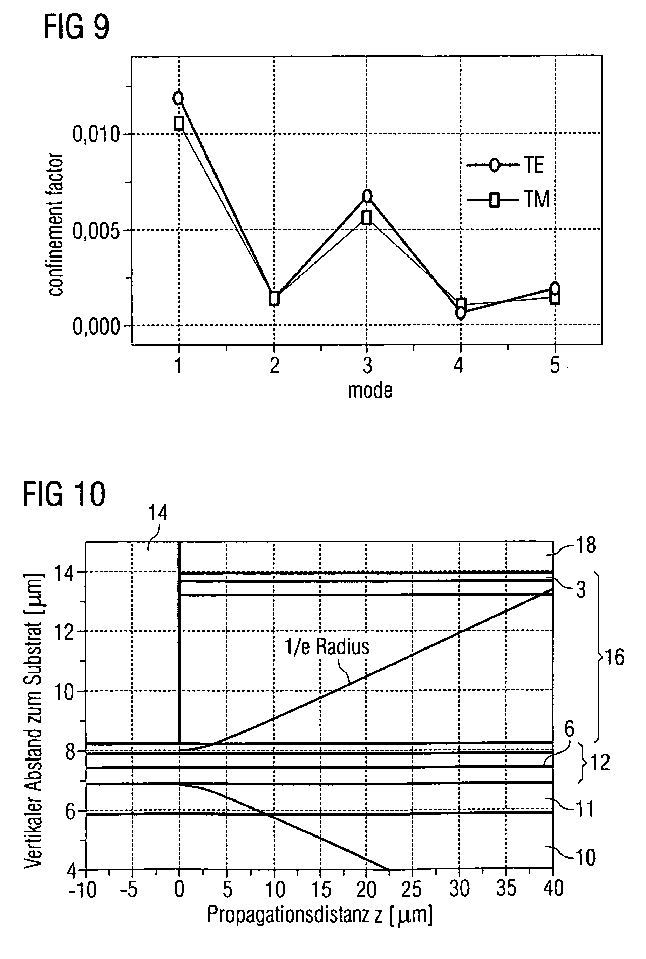

An den Pumpwellenleiter 12 bzw. die elektrisch leitende Schicht 13 grenzen im Vertikalemitterbereich 2 und in den Bereichen der Pumpstrahlungsquellen 5 unterschiedliche Schichten an (Ätzstoppschicht 17 und vertikale Wellenleiterstruktur 16 grenzen an den Vertikalemitterbereich 2 und die leitende und transparente Schicht 14 grenzt an die Pumpstrahlungsquellen 5). Es ergibt sich daraus ein effektiver Unterschied in der Brechungszahl des Pumpwellenleiters 12 innerhalb dieser unterschiedlichen Bereiche. Die Pumpstrahlung 7 erfährt somit Beugung beim Übergang von den Pumpstrahlungsquellen 5 in den Vertikalemitterbereich 2. Dadurch breitet sich die Pumpstrahlung 7 im Vertikalemitterbereich 2 in Form einer vertikalen Pumpmode aus, mit der die Vertikalemitterschicht 3 optisch gepumpt wird. Dieser Mechanismus wird weiter unten im Zusammenhang mit den Figuren 9 und 10 detaillierter dargestellt.

Wie die Pumpschicht 6 kann auch die Vertikalemitterschicht 3 durch eine einzelne Quantentopfstruktur oder durch eine Anordnung aus mehreren Quantentopfstrukturen gebildet sein. Die durch die Pumpmode in der Vertikalemitterschicht 3 oder in unmittelbar anliegenden Schichten freigesetzten Ladungsträger rekombinieren in der Vertikalemitterschicht 3 strahlend. Eine Absorption der Pumpmode in den oder der Quantentopfstruktur(en) und nicht den unmittelbar anliegenden Schichten ist geeigneter zu Erzielung einer guten Strahlqualität und von daher bevorzugt.

Ein Resonator, gebildet aus der Bragg-Spiegelstruktur 10 und einem hier nicht gezeigten externen Spiegel, formt das Strahlungsfeld 4. Eine hohe Pumpeffizienz lässt sich erreichen, indem die Wellenlänge der Pumpstrahlung 7 kleiner gewählt wird als die Wellenlänge des Strahlungsfeldes 4.

Um Absorptionsverluste im Strahlungsfeld durch die elektrisch leitende Schicht 13 zu minimieren, ist es günstig, die elektrisch leitende Schicht 13 in einem Knoten, also einem Intensitätsminimum, des Strahlungsfeldes im Resonator des Vertikalemitterbereich zu positionieren.

Sämtliche Halbleiterschichten im gezeigten Ausführungsbeispiel können in einem Expitaxieprozess hergestellt werden. Anschließend werden lateral selektiv die Bereiche der Pumpstrahlungsquellen 5 bis auf die elektrisch leitende Schicht 13 abgetragen. Dieses wird vorzugsweise in einem Ätzprozess durchgeführt. Um mit Hilfe des Ätzprozesses die elektrisch leitende Schicht 13 definiert freizulegen, ist direkt benachbart zur elektrisch leitenden Schicht die Ätzstoppschicht 17 vorgesehen, die gegenüber dem eingesetzten Ätzprozess resistent ist. Nach dem Ätzprozess wird die Ätzstoppschicht 17 ihrerseits durch einen geeigneten Prozess entfernt. Auf die auf diese Weise freigelegte elektrisch leitende Schicht 13 wird nachfolgend im Herstellungsprozess die leitende und transparente Schicht 14 und der weitere Kontakt 15 aufgebracht. Diese nicht kristallinen Schichten sind keinem streng kontrollierten epitaktischen Wachstumsprozess unterworfen und können auf einfache Weise aufgedampft werden.

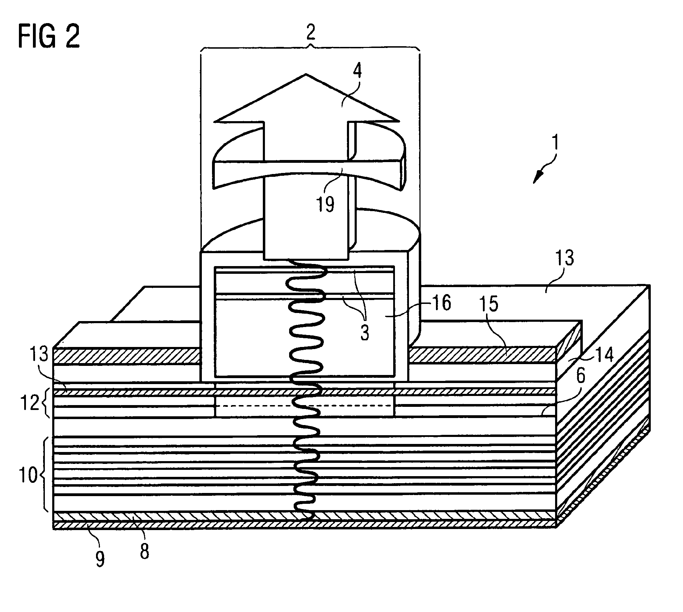

In Figur 2 ist eine dreidimensionale Schnittzeichnung des soeben erläuterten ersten Ausführungsbeispiels der erfindungsgemäßen Halbleiterlaservorrichtung dargestellt.

Zusätzlich zum Halbleiterkörper 1 ist in dieser Abbildung ein externer Resonatorspiegel 19 eingezeichnet. Der externe Resonatorspiegel 19 ist als halb durchlässiger Spiegel ausgeführt, der aus dem Strahlungsfeld 4 Laserstrahlung des Vertikalemitterbereichs 2 auskoppelt. Der Spiegel ist resonatorseitig zur Stabilisierung der resonatorinternen Strahlungsmoden gekrümmt ausgeführt.

In Figur 2 wird durch die perspektivische Ansicht deutlich, dass der Halbleiterkörper 1 mit Ausnahme des Vertikalemitterbereichs 2 bis auf die elektrisch leitende Schicht 13 abgetragen ist. Da es im Sinne einer hohen Pumpeffizienz nicht sinnvoll ist, die Pumpstrahlungsquellen 5 breiter auszulegen als den Durchmesser des Vertikalemitterbereichs 2 , sind die leitende und transparente Schicht 14 und der aufgebrachte Kontakt 15 in der gezeigten Form von Stegen auf die elektrisch leitende Schicht 13 aufgebracht.

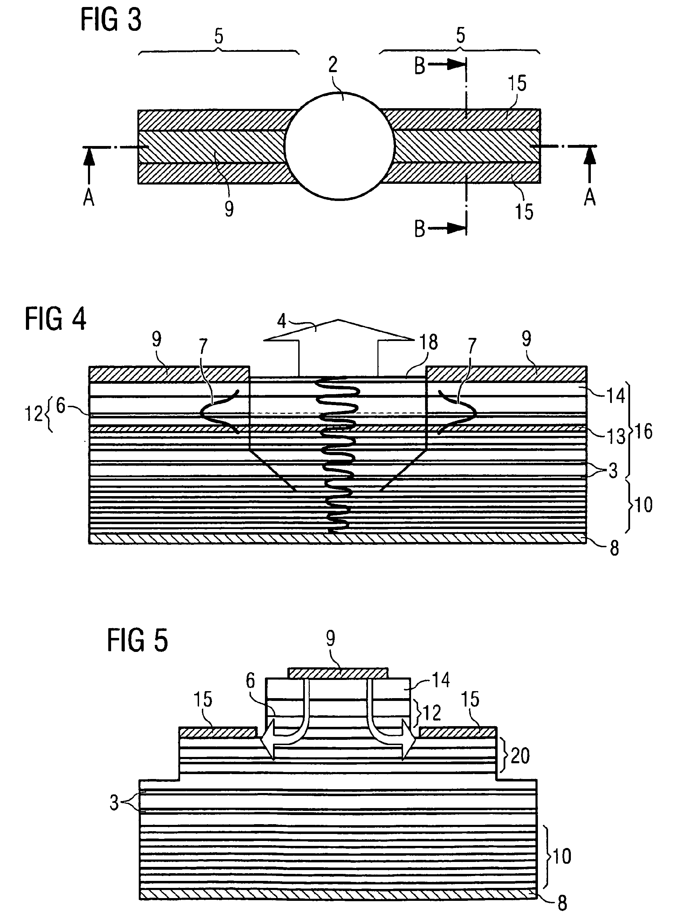

Figur 3 zeigt die schematische Aufsicht auf ein zweites Ausführungsbeispiel der Halbleiterlaservorrichtung. Auch in diesem Beispiel sind zwei Pumpstrahlungsquellen 5 benachbart zu einem zentralen Vertikalemitterbereich 2 angeordnet. Der Kontakt 9 ist in diesem Ausführungsbeispiel jedoch nicht auf der Rückseite des Substrats 8 vorgesehen, sondern auf der vom Substrat abgewandten Seite der Halbleiterlaservorrichtung.

In Figur 4 ist eine schematische Schnittdarstellung dieses Ausführungsbeispiels entlang der Schnittlinie AA von Figur 3 gezeigt. Die Anordnung der Schichten unterscheidet sich gegenüber dem ersten Ausführungsbeispiel vor allem darin, dass hier die Vertikalemitterschicht 3 näher an der Bragg-Spiegelstruktur 10 liegt als die Pumpschicht 6.

Bei diesem Ausführungsbeispiel kommen zwei Maßnahmen zum Einsatz, um eine Gleichberechtigung von Pumpschicht 6 und Vertikalemitterschicht 3 aufzuheben.

Zum einen werden, wie bereits beim ersten Ausführungsbeispiel, Ladungsträger nur in die Pumpschicht 6, nicht aber in die Vertikalemitterschicht 3 injiziert. Dieses wird durch eine Kontaktierung der Halbleiterlaservorrichtung über den Kontakt 9 sowie über den weiteren Kontakt 15, der seitlich mit der elektrisch leitenden Schicht 13 verbunden ist, erreicht. Der Kontakt 9 und die elektrisch leitende Schicht 13 umschließen somit die Pumpschicht 6, wohingegen die Vertikalemitterschicht 3 frei von statischen elektrischen Feldern ist.

Die zweite Maßnahme besteht darin, im Vertikalemitterbereich 2 eine bessere vertikale Wellenleitung für die Pumpstrahlung bereitzustellen als im Bereich der Pumpstrahlungsquellen 5. Zu diesem Zweck ist ein Teil der vertikalen Wellenleiterstruktur 16 als periodische Wellenleiterschichtstruktur 20 (RPG - Resonant Periodic Gain) ausgeführt. Bei einer Halbleiterlaservorrichtung auf der Basis des AlInGaAsP Materialsystems kann die periodische Wellenleiterschichtstruktur 20 beispielsweise hoch aluminiumhaltige AlGaAs-Schichten aufweisen. Solche hoch aluminiumhaltigen Schichten können durch ein nasschemisches Oxidationsverfahren von der Seite des Halbleiterkörpers 1 her definiert bis zum Übergangsbereich zwischen Pumplaserstrukturen 5 und Vertikalemitterbereich 2 durchoxidiert werden, wodurch der Brechungsindex im oxidierten Bereich um bis zu etwa 50 % verändert werden kann.

Der oxidierte Teil der periodischen Wellenleiterschichtstruktur 20 erfüllt für die Pumpstrahlung 7 keine Resonanzbedingung nicht mehr, weswegen sie in diesem Bereich keinen guten Wellenleiter in vertikaler Richtung darstellt. Die Massnahme, die vertikale Wellenleitung im Bereich der Pumpstrahlungsquellen nachträglich, z.B. durch Oxidation, zu verändern ist selbstverständlich nicht auf die periodische Wellenleiterschichtstruktur 20 beschränkt, sondern kann im Rahmen der Erfindung gleichermaßen auf die gesamte vertikale Wellenleiterstruktur 16 oder beliebige Teile davon ausgedehnt werden.

In Figur 5 ist eine schematische Schnittansicht des zweiten Ausführungsbeispiels entlang der Linie BB gezeigt.

In dieser Darstellung ist ersichtlich, dass die Halbleiterlaservorrichtung zu beiden Seiten des Pumpbereichs bis auf die elektrisch leitende Schicht 13 abgetragen ist. Wiederum ist direkt benachbart zur elektrisch leitenden Schicht 13 eine Ätzstoppschicht 17 vorgesehen, um das Abtragen durch einen definiert stoppbaren Ätzprozess zu realisieren. Auf die freigelegte elektrisch leitende Schicht 13 ist beidseitig der weitere Kontakt 15 in Form von Kontaktstreifen aufgebracht. Die eingezeichneten Strompfade 21 verdeutlichen den Stromfluss innerhalb der Pumpstrahlungsquellen 5.

In einem zweiten Ätzprozess ist die Halbleiterlaservorrichtung im Außenbereich so weit abgetragen, dass die Kanten der periodischen Wellenleiterschichtstruktur 20 auch im Waferverbund der nasschemischen Oxidation zugänglich sind.

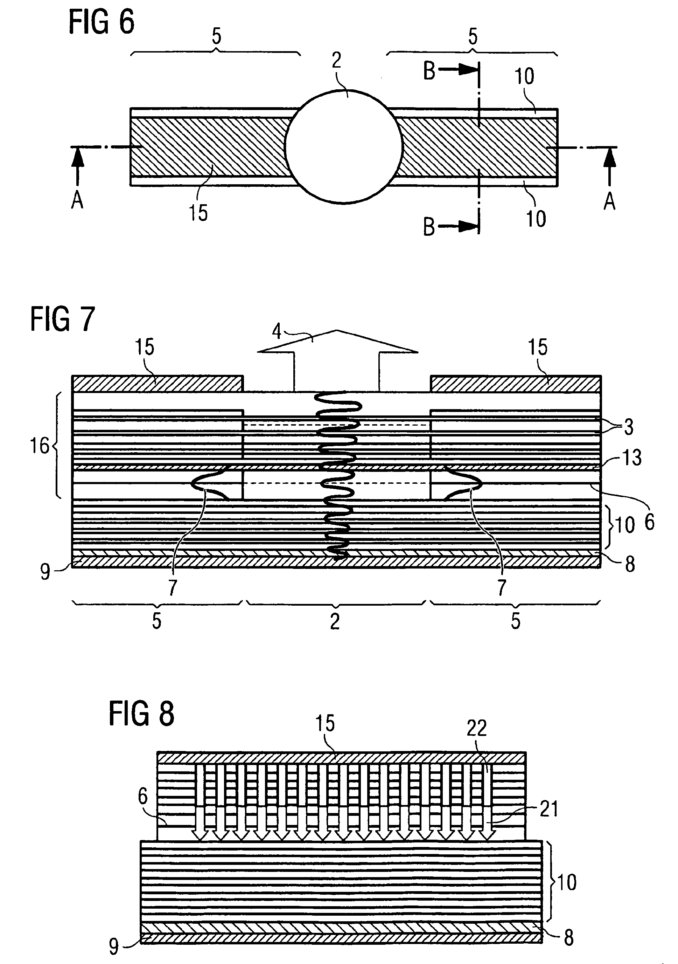

Analog zu den Figuren 3, 4 und 5 ist in den Figuren 6, 7 und 8 die schematische Aufsicht sowie zwei schematische Schnittbilder eines dritten Ausführungsbeispiels der erfindungsgemäßen Halbleiterlaservorrichtung gezeigt.

Wiederum werden zwei Maßnahmen zur Aufhebung der Gleichberechtigung von Vertikalemitterschicht 3 und Pumpschicht 6 eingesetzt. Bei diesem Ausführungsbeispiel ist zwischen den beiden Kontakte 9 und 15 die gesamte Schichtabfolge der Halbleiterlaservorrichtung angeordnet. Die Anordnung der Schichten entspricht im Wesentlichen dem ersten gezeigten Ausführungsbeispiel (Pumpschicht 6 näher an der Bragg-Spiegelstruktur 10 als die Vertikalemitterschicht 3), wobei zwischen der Pumpschicht 6 und der Vertikalemitterschicht 3 wiederum die periodische Wellenleiterschichtstruktur 20 angeordnet ist.

Im Unterschied zum ersten Ausführungsbeispiel ist in diesem Fall die Halbleiterlaserstruktur im Bereich der Pumpstrahlungsquellen 5 nicht flächig abgetragen, sondern in Form von schmalen parallelen Gräben 22, wie aus Figur 8 ersichtlich ist. Diese Gräben 22 sind bis auf die Tiefe einer wiederum direkt der elektrisch leitenden Schicht 13 benachbarten Ätzstoppschicht 17 in den Halbleiterkörper 1 eingeätzt.

Im Bereich der Pumpstrahlungsquellen 5 durchschneiden diese Gräben somit auch die periodische Wellenleiterschichtstruktur 20. Diese Gräben können somit vorteilhaft zur nasschemischen Oxidation der periodischen Wellenleiterschichtstruktur 20 genutzt werden. Alternativ oder zusätzlich können breitere Gräben im Außenbereich der Halbleiterlaservorrichtung zur Oxidation vorgesehen sein, wie bereits beim zweiten Ausführungsbeispiel beschrieben. Nach erfolgter Oxidation der periodischen Wellenleiterschichtstruktur 20 werden die Gräben 22 mit leitendem Material gefüllt, bevor der Kontakt 15 aufgebracht wird. In einer vorteilhaften Ausführungsform wird als leitendes Material, entweder über die gesamte Tiefe der Gräben 22 oder auch nur im unteren, an die elektrisch leitende Schicht 13 angrenzenden Bereich, ein leitendes und transparentes Material eingesetzt. Wiederum kommt hier ITO oder eine zinkoxidhaltige Verbindung als Material in Frage.

Figur 9 zeigt graphisch die Überlappung der Pumpstrahlung 7 mit verschiedenen Strahlungsmoden des Vertikalemitterbereichs 2. Die Überlappung wird als dimensionsloser Confinement Factor für die ersten fünf transversal-elektrischen (TE) und transversal-magnetischen (TM) Moden des Vertikalemitterbereichs 2 angegeben. Die gezeigten Daten sind Ergebnisse von Untersuchungen zu dem in Figur 1 gezeigten Ausführungsbeispiel.

Es ergibt sich eine gute Überlappung für die erste TE/TM-Grundmode, die somit bevorzugt im Resonator verstärkt und von der Halbleiterlaser-Anordnung emittiert wird. Das Ergebnis zeigt, dass sich erfindungsgemäß eine Halbleiterlaservorrichtung mit nahezu perfekter TEM₀₀-Strahlqualität realisieren lässt.

In Figur 10 ist graphisch dargestellt, wie sich die Pumpstrahlung 7 beim Übergang von den Pumpstrahlungsquellen 5 in den Vertikalemitterbereich 2 in vertikaler Richtung ausbreitet. Es ist die Ortslinie eingetragen, an der das Pumpstrahlungsfeld auf den Faktor 1/e seines ursprünglichen Wertes abgesunken ist. Auf der Ordinate ist der vertikale Abstand zum Substrat in Mikrometern angegeben und auf der Abszisse die Strecke, die die Strahlung in lateraler Richtung in den Vertikalemitterbereich 2 zurückgelegt hat. Zur besseren Orientierung sind die verschiedenen Schichten der Halbleiterlaservorrichtung als horizontale Linien in das Diagramm eingetragen und mit Bezugszeichen versehen. Es zeigt sich, dass bereits 40 µm nach Austritt aus der Pumpstrahlungsquelle die Intensität der Pumpmode etwa 1/e (37 %) ihrer Maximalintensität beträgt. Die Pumpstrahlungsintensität an der Vertikalemitterschicht 3 steigt somit in Richtung des Zentrums des Vertikalemitterbereichs 2, was den großen Überlapp der Pumpmode mit der TEM₀₀-Grundmode des Vertikalemitterbereichs 2 erklärt.

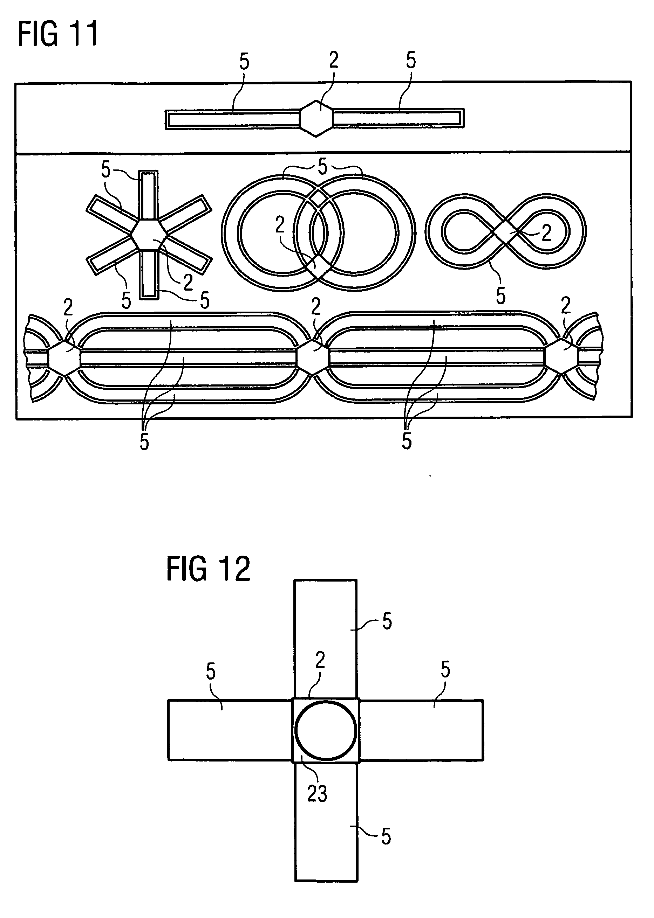

Figur 11 zeigt eine Aufsicht auf verschiedene Ausführungsformen der erfindungsgemäßen Halbleiterlaservorrichtung.

Dadurch, dass die erfindungsgemäße Halbleiterlaservorrichtung in einem Einschritt-Epitaxie-Verfahren herstellbar ist, eröffnet sich die Möglichkeit, auf relativ einfache Weise verschiedenste, auch komplexe Anordnungen von Vertikalemitterbereich 2 und Pumpstrahlungsquellen 5 zueinander zu realisieren. Einige denkbare Möglichkeiten sind in Figur 11 gezeigt.

Oben in der Figur ist eine den bisher beschriebenen Ausführungsformen ähnliche Anordnung mit zwei sich gegenüberliegenden linearen Pumpstrahlungsquellen 5, die seitlich benachbart zu einem zentralen, hier sechseckig ausgeführten Vertikalemitterbereich 2 liegen, dargestellt. Mittig links in der Figur 11 ist eine ähnliche Anordnung gezeigt, bei der sich sechs Pumpstrahlungsquellen 5 jeweils paarweise gegenüberstehen. In der Mitte der Figur 11 ist eine Anordnung gezeigt, bei der der Vertikalemitterbereich 2 quadratisch ausgelegt ist und bei der zwei als Ringlaser ausgeführte Pumpstrahlungsquellen 5 vorgesehen sind, die sich derart überlappen, dass sie sich im Vertikalemitterbereich 2 kreuzen. Dazu ähnlich ist die rechts dargestellte Anordnung, bei der ein Ringlaser 5 vorhanden ist, der zu einer "8" gewunden ist, in deren Kreuzungspunkt wiederum der Vertikalemitterbereich 2 angeordnet ist. Die angegebenen, auf Wellenleitung basierenden Ringlaserstrukturen haben den Vorteil, dass auf Resonatorendspiegel verzichtet werden kann und eventuelle Verluste an diesen Resonatorendspiegeln entfallen. Unten in der Figur 11 ist eine Anordnung gezeigt, bei der mehrere, in einer Reihe liegende sechseckige Vertikalemitterbereiche 2 vorgesehen sind, die von verschiedenen linearen oder auch gekrümmten Pumpstrahlungsquellen 5 gepumt werden.

In Figur 12 ist schematisch die Aufsicht auf ein weiteres Ausführungsbeispiel der erfindungsgemäßen Halbleiterlaservorrichtung gezeigt, bei der vier Pumpstrahlungsquellen 5 einen quadratischen Vertikalemitterbereich 2 pumpen.

Figur 12 illustriert eine Maßnahme, um auch bei einem nicht runden, hier quadratischen, Vertikalemitterbereich 2 ein möglichst radialsymmetrisches Strahlprofil zu erreichen. Nicht runde Vertikalemitterbereich 2 ergeben sich beispielsweise fast unvermeidlich bei den in Figur 11 gezeigten Ausführungsbeispielen, bei denen sich eine als Ringlaser ausgeführte Pumpstrahlungsquelle 5 in einem Vertikalemitterbereich 2 überkreuzt. Bei dieser Maßnahme wird in einem Außenbereich 23 des Vertikalemitterbereichs 2 die Vertikalemitterschicht 3, z.B. durch Ionenstrahlbeschuss, so verändert, dass sie in diesem Bereich das Pumplicht der Pumpstrahlungsquellen 5 mit einer geringeren Effizienz absorbiert als in dem inneren, möglichst kreisrund ausgeführten, nicht veränderten Bereich.

## Patentansprüche

1. Halbleiterlaservorrichtung mit
- einem optisch gepumpten, oberflächenemittierenden Vertikalemitterbereich (2), der eine aktive strahlungserzeugende Vertikalemitterschicht (3) aufweist, und
- mindestens einer monolithisch integrierten Pumpstrahlungsquelle (5) zum optischen Pumpen des Vertikalemitters (2), die einen lateralen Pumpwellenleiter (12) mit einer aktive Pumpschicht (6) zur Erzeugung von Pumpstrahlung aufweist, wobei
- die Pumpstrahlung eine laterale Hauptstrahlungsrichtung aufweist,
- die Pumpschicht (6) der Vertikalemitterschicht (3) in vertikaler Richtung nachgeordnet ist,
- eine elektrisch leitende Schicht (13) zwischen der Vertikalemitterschicht (3) und der Pumpschicht (6) vorgesehen ist,
- ein Kontakt (9) auf der Seite der Halbleiterlaservorrichtung aufgebracht ist, die sich näher an der Pumpschicht (6) als an der elektrisch leitenden Schicht (13) befindet, und
- zwischen der elektrisch leitenden Schicht (13) und dem Kontakt (9) ein elektrisches Feld zur Erzeugung der Pumpstrahlung (7) durch Ladungsträgerinjektion anlegbar ist,
**dadurch gekennzeichnet, dass**
- der Pumpwellenleiter (12) einen lateralen Bereich mit einem von dem übrigen Teil des Pumpwellenleiters (12) abweichenden Brechungsindex aufweist, durch den die Pumpstrahlung (7) in Richtung der Vertikalemitterschicht (3) gebrochen wird und
- eine vertikale Wellenleiterstruktur (16) derart vorgesehen ist, dass die Pumpstrahlung (7) die Vertikalemitterschicht (3) erreicht.

2. Halbleiterlaservorrichtung nach Anspruch 1, **dadurch gekennzeichnet, dass**
die Halbleiterlaservorrichtung teilweise abgetragen ist, so dass die elektrisch leitende Schicht (13) teilweise freigelegt ist.

3. Halbleiterlaservorrichtung nach Anspruch 2, **dadurch gekennzeichnet, dass**
die Halbleiterlaservorrichtung in Form von parallelen Gräben (22) abgetragen ist.

4. Halbleiterlaservorrichtung nach Anspruch 2 oder 3, **dadurch gekennzeichnet, dass**
auf die freigelegten Bereiche der elektrisch leitenden Schicht (13) ein weiterer Kontakt (15) aufgebracht ist.

5. Halbleiterlaservorrichtung nach Anspruch 4, **dadurch gekennzeichnet, dass**
zwischen der elektrisch leitenden Schicht (13) und dem weiteren Kontakt (15) eine Schicht (14) vorgesehen ist, die leitend ist und die für Strahlung einer Wellenlänge, wie sie von der Pumpstrahlungsquelle (5) erzeugt wird, transparent ist.

6. Halbleiterlaservorrichtung nach einem der Ansprüche 2 bis 5, **dadurch gekennzeichnet, dass**
benachbart zur elektrisch leitenden Schicht (13) eine Ätzstopschicht (17) vorgesehen ist, die resistent gegenüber einem Ätzprozess ist, der geeignet ist, die leitende Schicht (13) freizulegen.

7. Halbleiterlaservorrichtung nach einem der Ansprüche 1 bis 6, **dadurch gekennzeichnet, dass**
die elektrisch leitende Schicht (13) vertikal so angeordnet ist, dass sie sich in einem Knoten des Strahlungsfeldes in dem Resonator des Vertikalemitterbereichs (2) befindet.

8. Halbleiterlaservorrichtung nach einem der Ansprüche 4 bis 7, **dadurch gekennzeichnet, dass**
zwischen der Vertikalemitterschicht (3) und der elektrisch leitenden Schicht (13) die vertikale Wellenleiterstruktur (16) vorgesehen ist.

9. Halbleiterlaservorrichtung nach Anspruch 8, **dadurch gekennzeichnet, dass**
die vertikale Wellenleiterstruktur (16) in dem Bereich, in dem sie, lateral gesehen, zwischen dem Kontakt (9) und dem weiteren Kontakt (15) liegt, andere optische Eigenschaften aufweist, als in dem Bereich, in dem sie nicht zwischen dem Kontakt (9) und dem weiteren Kontakt (15) liegt.

10. Halbleiterlaservorrichtung nach Anspruch 9, **dadurch gekennzeichnet, dass**
die vertikale Wellenleiterstruktur (16) in dem Bereich, in dem sie, lateral gesehen, zwischen dem Kontakt (9) und dem weiteren Kontakt (15) liegt, oxidiert ist.

11. Halbleiterlaservorrichtung nach einem der Ansprüche 1 bis 10, **dadurch gekennzeichnet, dass**
der Pumpschicht (6) und der Vertikalemitterschicht (3) in vertikaler Richtung eine interne Resonatorspiegelstruktur nachgeordnet ist.

12. Halbleiterlaservorrichtung nach Anspruch 11, **dadurch gekennzeichnet, dass**
die internen Resonatorspiegelstruktur eine Bragg-Spiegelstruktur (10) ist.

13. Halbleiterlaservorrichtung nach einem der Ansprüche 11 oder 12, **dadurch gekennzeichnet, dass**
die internen Resonatorspiegelstruktur zwischen der Vertikalemitterschicht (3) und einem Substrat (8) angeordnet ist und die von der Vertikalemitterschicht (3) erzeugte Strahlung auf der dem Substrat gegenüberliegenden Seite ausgekoppelt wird.

14. Halbleiterlaservorrichtung nach einem der Ansprüche 1 bis 13, **dadurch gekennzeichnet, dass**
der Vertikalemitterschicht (3) ein externer Resonatorpiegel (19) zugeordnet ist, der zusammen mit der internen Resonatorspiegelstruktur den Resonator für den Vertikalemitterbereich (2) bildet.

15. Halbleiterlaservorrichtung nach Anspruch 14, **dadurch gekennzeichnet, dass**
im Resonator strahlformende Elemente angeordnet sind.

16. Halbleiterlaservorrichtung nach einem der Ansprüche 14 oder 15, **dadurch gekennzeichnet, dass**
im Resonator frequenzselektive Elemente angeordnet sind.

17. Halbleiterlaservorrichtung nach einem der Ansprüche 14 bis 16, **dadurch gekennzeichnet, dass**
im Resonator frequenzkonvertierende Elemente angeordnet sind.

18. Halbleiterlaservorrichtung nach einem der Ansprüche 1 bis 17, **dadurch gekennzeichnet, dass**
die Vertikalemitterschicht (3) und/oder die Pumpschicht (6) jeweils eine oder mehrere Quantentopfstrukturen aufweist.

19. Halbleiterlaservorrichtung nach Anspruch 14, **dadurch gekennzeichnet, dass**
die Quantentopfstrukturen Quantentröge, Quantendrähte, Quantenpunkte und jede Kombination dieser Strukturen enthalten können.

## Claims

1. Semiconductor laser device comprising
- an optically pumped surface-emitting vertical emitter region (2) which has an active radiation-emitting vertical emitter layer (3) and
- at least one monolithically integrated pump radiation source (5) for optically pumping the vertical emitter (2), which has a lateral pump waveguide (12) having an active pump layer (6) for generating pump radiation, where
- the pump radiation has a lateral main direction of radiation,
- the pump layer (6) follows the vertical emitter layer (3) in the vertical direction,
- an electrically conductive layer (13) is provided between the vertical emitter layer (3) and the pump layer (6),
- a contact (9) is applied on the side of the semiconductor laser device which is closer to the pump layer (6) than to the electrically conductive layer (13), and
- an electrical field can be applied between the electrically conductive layer (13) and the contact (9) for generating the pump radiation (7) by charge carrier injection,
**characterized in that**
- the pump waveguide (12) has a lateral region having a refractive index, deviating from the remaining part of the pump waveguide, by means of which the pump radiation (7) is refracted in the direction of the vertical emitter layer (3), and
- a vertical waveguide structure (16) is provided in such a manner that the pump radiation (7) reaches the vertical emitter layer (3).

2. Semiconductor laser device according to Claim 1, **characterized in that** the semiconductor laser device is partially ablated so that the electrically conductive layer (13) is partially exposed.

3. Semiconductor laser device according to Claim 2, **characterized in that** the semiconductor laser device is ablated in the form of parallel trenches (22).

4. Semiconductor laser device according to Claim 2 or 3, **characterized in that** a further contact (15) is applied to the exposed areas of the electrically conductive layer (13).

5. Semiconductor laser device according to Claim 4, **characterized in that** a layer (14) which is conductive and which is transparent for radiation of a wavelength as generated by the pump radiation source (5) is provided between the electrically conductive layer (13) and the further contact (15).

6. Semiconductor laser device according to one of Claims 2 to 5, **characterized in that** an etch stop layer (17) which is resistant to an etching process which is suitable for exposing the conductive layer (13) is provided adjacently to the electrically conductive layer (13).

7. Semiconductor laser device according to one of Claims 1 to 6, **characterized in that** the electrically conductive layer (13) is arranged vertically in such a manner that it is located in a node of the radiation field in the resonator of the vertical emitter region (2).

8. Semiconductor laser device according to one of Claims 4 to 7, **characterized in that** the vertical waveguide structure (16) is provided between the vertical emitter layer (3) and the electrically conductive layer (13).

9. Semiconductor laser device according to Claim 8, **characterized in that** the vertical waveguide structure (16) has other optical characteristics in the region in which it is located between the contact (9) and the further contact (15), seen laterally, than in the region in which it is not located between the contact (9) and the further contact (15).

10. Semiconductor laser device according to Claim 9, **characterized in that** the vertical waveguide structure (16) is oxidized in the region in which it is located between the contact (9) and the further contact (15), seen laterally.

11. Semiconductor laser device according to one of Claims 1 to 10, **characterized in that** the pump layer (6) and the vertical emitter layer (3) are followed in the vertical direction by an internal cavity facet structure.

12. Semiconductor laser device according to Claim 11, **characterized in that** the internal cavity facet structure is a Bragg reflector structure (10).

13. Semiconductor laser device according to one of Claims 11 or 12, **characterized in that** the internal cavity facet structure is arranged between the vertical emitter layer (3) and a substrate (8) and the radiation generated by the vertical emitter layer (3) is launched on the side opposite the substrate.

14. Semiconductor laser device according to one of Claims 1 to 13, **characterized in that** the vertical emitter layer (3) is associated with an external resonator reflector (19) which, together with the internal cavity facet structure, forms the resonator for the vertical emitter region (2).

15. Semiconductor laser device according to Claim 14, **characterized in that** beam-shaping elements are arranged in the resonator.

16. Semiconductor laser device according to one of Claims 14 or 15, **characterized in that** frequency-selective elements are arranged in the resonator.

17. Semiconductor laser device according to one of Claims 14 to 16, **characterized in that** frequency-converting elements are arranged in the resonator.

18. Semiconductor laser device according to one of Claims 1 to 17, **characterized in that** the vertical emitter layer (3) and/or the pump layer (6) in each case have one or more quantum well structures.

19. Semiconductor laser device according to Claim 14, **characterized in that** the quantum well structures can contain quantum troughs, quantum wires, quantum dots and any combination of these structures.

## Revendications

1. Dispositif laser à semi-conducteurs, qui présente
- une partie verticale d'émetteur (2) pompée optiquement, émettant en surface et dotée d'une couche active verticale d'émetteur (3) qui produit un rayonnement et
- au moins une source (5) de rayonnement de pompage, intégrée monolithiquement, qui pompe optiquement l'émetteur vertical (2) et qui présente un guide latéral (12) d'onde de pompage dotée d'une couche active de pompage (6) qui produit un rayonnement de pompage,
le rayonnement de pompage présentant une direction principale latérale de rayonnement,
la couche de pompage (6) étant disposée en aval de la couche verticale d'émetteur (3) dans la direction verticale,
- une couche électriquement conductrice (13) étant prévue entre la couche verticale d'émetteur (3) et la couche de pompage (6),
un contact (9) situé plus près de la couche de pompage (6) que de la couche électriquement conductrice (13) étant ménagé sur le côté du dispositif laser à semi-conducteurs et
un champ électrique qui produit le rayonnement de pompage (7) par injection de porteurs de charge pouvant être appliqué entre la couche électriquement conductrice (13) et le contact (9),
**caractérisé en ce que**
le guide (12) d'onde de pompage présente une partie latérale dont l'indice de réfraction est différent de celui de la partie restante du guide (12) d'onde de pompage et par laquelle le rayonnement de pompage (7) est réfractée en direction de la couche verticale d'émetteur (3) et
**en ce qu'**une structure verticale (16) de guide d'onde est prévue de telle sorte que le rayonnement de pompage (7) atteigne la couche verticale d'émetteur (3).

2. Dispositif laser à semi-conducteurs selon la revendication 1, **caractérisé en ce qu'**une partie du dispositif laser à semi-conducteur est enlevée de manière à libérer une partie de la couche électriquement conductrice (13).

3. Dispositif laser à semi-conducteurs selon la revendication 2, **caractérisé en ce que** le dispositif laser à semi-conducteurs est enlevé sous la forme de rainures parallèles (22).

4. Dispositif laser à semi-conducteurs selon les revendications 2 ou 3, **caractérisé en ce qu'**un autre contact (15) est ménagé sur les parties libérées de la couche électriquement conductrice (13).

5. Dispositif laser à semi-conducteurs selon la revendication 4, **caractérisé en ce qu'**une couche (14) conductrice et transparente au rayonnement à la longueur d'onde produite par la source (5) de rayonnement de pompage est prévue entre la couche électriquement conductrice (13) et l'autre contact (15).

6. Dispositif laser à semi-conducteurs selon l'une des revendications 2 à 5, **caractérisé en ce qu'**une couche (17) d'arrêt de gravure qui résiste à une opération de gravure qui permet de libérer la couche conductrice (13) est prévue au voisinage de la couche électriquement conductrice (13).

7. Dispositif laser à semi-conducteurs selon l'une des revendications 1 à 6, **caractérisé en ce que** la couche électriquement conductrice (13) est disposée verticalement de manière à être située en un noeud du champ de rayonnement dans le résonateur de la partie verticale d'émetteur (2).

8. Dispositif laser à semi-conducteurs selon l'une des revendications 4 à 7, **caractérisé en ce que** la structure verticale de guide d'onde (16) est prévue entre la couche verticale d'émetteur (3) et la couche électriquement conductrice (13).

9. Dispositif laser à semi-conducteurs selon la revendication 8, **caractérisé en ce que** dans la partie dans laquelle, vue latéralement, la structure verticale (16) de guide d'onde est située entre le contact (9) et l'autre contact (15), elle présente d'autres propriétés optiques que dans la partie dans laquelle elle n'est pas située entre le contact (9) et l'autre contact (15).

10. Dispositif laser à semi-conducteurs selon la revendication 9, **caractérisé en ce que** la structure verticale (16) de guide d'onde est oxydée dans la partie dans laquelle, vue latéralement, elle est située entre le contact (9) et l'autre contact (15).

11. Dispositif laser à semi-conducteurs selon l'une des revendications 1 à 10, **caractérisé en ce qu'**une structure interne de miroir de résonateur est disposée en aval de la couche de pompage (6) et de la couche verticale d'émetteur (3) dans la direction verticale.

12. Dispositif laser à semi-conducteurs selon la revendication 11, **caractérisé en ce que** la structure interne de miroir de résonateur est une structure (10) en miroir de Bragg.

13. Dispositif laser à semi-conducteurs selon l'une des revendications 11 ou 12, **caractérisé en ce que** la couche interne de miroir de résonateur est disposée entre la couche verticale d'émetteur (3) et un substrat (8) et **en ce que** le rayonnement produit par la couche verticale d'émetteur (3) est émis sur le côté opposé au substrat.

14. Dispositif laser à semi-conducteurs selon l'une des revendications 1 à 13, **caractérisé en ce qu'**un miroir externe de résonateur (19) qui forme avec la structure interne de miroir de résonateur le résonateur de la partie verticale d'émetteur (2) est associé à la couche verticale d'émetteur (3).

15. Dispositif laser à semi-conducteurs selon la revendication 14, **caractérisé en ce que** des éléments de formation de faisceau sont disposés dans le résonateur.

16. Dispositif laser à semi-conducteurs selon l'une des revendications 14 ou 15, **caractérisé en ce que** des éléments sélectifs en fréquence sont disposés dans le résonateur.

17. Dispositif laser à semi-conducteurs selon l'une des revendications 14 à 16, **caractérisé en ce que** des éléments de conversion de fréquence sont disposés dans le résonateur.

18. Dispositif laser à semi-conducteurs selon l'une des revendications 1 à 17, **caractérisé en ce que** la couche verticale d'émetteur (3) et/ou la couche de pompage (6) présentent toutes deux une ou plusieurs structures en cuvette quantique.

19. Dispositif laser à semi-conducteurs selon la revendication 14, **caractérisé en ce que** les structures en cuvette quantique peuvent contenir des cuvettes quantiques, des fils quantiques, des points quantiques ou une quelconque combinaison de ces structures.
